# FASCICULE DE BREVET EUROPEEN

(11) **EP 3 134 366 B1**
(45) Date de publication et mention de la délivrance du brevet: **16.01.2019**
(21) Numéro de dépôt: 15725771.8
(22) Date de dépôt: 21.04.2015
(51) Int. Cl.: C03C 8/14, C03C 17/00, C03C 17/34

(54) **PROCEDE DE FABRICATION D'UN SUBSTRAT EN VERRE MUNI DE MOTIFS IMPRIMES ET D'UNE SOUS-COUCHE DE PROTECTION POUR VISION A SENS UNIQUE**
VERFAHREN ZUR HERSTELLUNG EINES GLASSUBSTRATS MIT GEDRUCKTEN MUSTERN UND EINER SCHÜTZENDEN UNTERSCHICHT FÜR EINSEITIGE BLICKRICHTUNG
PROCESS FOR MANUFACTURING A GLASS SUBSTRATE EQUIPPED WITH PRINTED PATTERNS AND A PROTECTIVE UNDERLAYER FOR ONE-WAY VISION

(30) Priorité: 24.04.2014 FR 1453709
(43) Date de publication de la demande: 01.03.2017
(73) Titulaire: Saint-Gobain Glass France, 92400 Courbevoie (FR)
(72) Inventeur: CHAHBOUNE, Kamel, 02200 Soissons (FR); DUCOURTHIAL, Elodie, 60200 Compiegne (FR)
(74) Mandataire: Saint-Gobain Recherche
(86) Numéro de dépôt international: PCT/FR2015/051079
(87) Numéro de publication internationale: WO 2015/162375

(56) Documents cités:
- WO-A1-2012/172269
- M. MAZUR ET AL: "TiO2/SiO2 multilayer as an antireflective and protective coating deposited by microwave assisted magnetron sputtering", OPTO-ELECTRONICS REVIEW, vol. 21, no. 2, 15 mars 2013 (2013-03-15), pages 233-238, XP055157897, ISSN: 1230-3402, DOI: 10.2478/s11772-013-0085-7

## Description

La présente invention se rapporte au domaine des substrats en verre imprimés comportant des motifs à base d'émail.

Les substrats en verre imprimés sont utilisés dans des applications variées, dans un but décoratif et/ou fonctionnel, comme par exemple en tant que vitrages pour bâtiments ou automobiles. La demande de brevet WO 2012/172269 décrit un procédé de fabrication d'un panneau en verre à vision à sens unique (« one way vision » en anglais). Ce type de vitrage permet à un observateur se trouvant à l'intérieur d'un bâtiment ou d'un véhicule d'avoir une vision normale de l'environnement extérieur, alors qu'un observateur se situant à l'extérieur n'aura aucune vision sur l'intérieur. De tels vitrages sont obtenus en appliquant une première couche de pigments, souvent d'une couleur noire, exempte de fritte de verre, directement sur le substrat en verre sous la forme des motifs désirés, puis en déposant une seconde couche d'émail comprenant une fritte de verre et des pigments d'une couleur claire différente du noir, par exemple blanc, sur l'ensemble des motifs. L'ensemble est porté à une température suffisante pour cuire l'émail. Pendant la phase de cuisson de l'émail, la fritte de verre présente dans la seconde couche d'émail se ramollit et s'accroche au verre du substrat en retenant les pigments noirs. Après cuisson, les pigments noirs déposés en dehors des motifs, non fixés par l'émail sont éliminés par un traitement approprié, par exemple par aspiration sous vide ou par application d'un jet d'air ou d'eau. Pour éviter la migration des pigments noirs dans une couche de couleur claire comme le blanc et ainsi éviter que le blanc soit perçu avec une teinte grisâtre, la demande WO 2012/172269 propose d'une part d'utiliser des pigments et des frittes de verre dont les particules ont une dimension similaire, et d'autre part de déposer une épaisseur plus épaisse de la seconde couche d'émail, l'épaisseur de la couche de pigments avant cuisson ou chauffage étant comprise entre 4 et 15 µm et l'épaisseur de la couche d'émail avant cuisson ou chauffage étant comprise entre 20 et 100 µm. L'étape de fixation des pigments sur le verre est réalisée par cuisson qui est généralement opérée entre 600 et 700°C. Or, il s'avère que certains échantillons restent teintés après cuisson, notamment en raison de la migration de certains composés des pigments noirs, aux endroits qui n'ont pas été recouverts par l'émail blanc. Cet aspect teinté est d'autant plus marqué que la température à laquelle la cuisson a été effectuée est élevée. Même après nettoyage du substrat en verre, cette coloration noire ne disparait pas et s'explique probablement par une migration des pigments noirs vers la surface du verre. La teinte du verre n'est toutefois pas permanente et elle disparait par lixiviation ou attaque chimique, par exemple par attaque acide. Toutefois, cette variation de teinte en fonction de la cuisson et du temps ne permet pas d'obtenir un produit stable tout au long de la durée de vie du produit. La présente invention permet d'obvier aux inconvénients explicités ci-dessus.

La présente invention porte sur un procédé de fabrication d'un panneau en verre à vision à sens unique comportant un ou plusieurs motifs discrets en émail, composés de plusieurs couches en exacte coïncidence, procédé selon lequel :
a) on dépose sur le substrat en verre au moins une couche de protection à base d'oxydes d'une épaisseur supérieure ou égale à 10 nm,
b) on dépose sur la couche de protection au moins deux couches de composition différentes, la composition de l'une des couches renfermant au moins un pigment minéral et étant exempte de fritte de verre, la composition de l'autre couche étant un émail renfermant au moins une fritte de verre et au moins un pigment minéral de couleur différente de celui de la couche exempte de fritte de verre, la couche exempte de fritte de verre étant déposée sur tout ou partie de la surface du panneau et la couche d'émail étant déposée par sérigraphie sous la forme du ou des motifs désirés,
c) on chauffe le panneau revêtu desdites couches à une température suffisante pour cuire l'émail, et
d) on élimine les pigments non fixés par l'émail situés en dehors du ou des motifs, les particules de pigment(s) et les particules de(s) fritte(s) de verre ayant une dimension similaire, notamment une distribution granulométrique telle que 50 % des particules ont une taille inférieure à 7 µm.

Selon un premier mode de réalisation, lors de l'étape b), on dépose sur la couche de protection la couche exempte de fritte de verre sur une épaisseur comprise entre 4 et 15 µm, sur toute ou partie de la surface du panneau puis on dépose par sérigraphie la couche d'émail sur une épaisseur comprise entre 10 et 100 µm sous la forme du ou des motifs désirés.

Selon un autre mode de réalisation, lors de l'étape b), on dépose sur la couche de protection la couche d'émail sur une épaisseur comprise entre 10 et 100 µm sous la forme du ou des motifs désirés, puis on dépose la couche exempte de fritte de verre sur une épaisseur comprise entre 4 et 30 µm, sur toute ou partie de la surface du panneau.

Les épaisseurs données pour chacune des couches déposées lors de l'étape b) sont mesurées sur des couches humides, c'est-à-dire avant l'étape de cuisson c).

Chaque dépôt successif des couches réalisé à l'étape b) est avantageusement suivi d'une étape de traitement thermique avant de déposer la seconde couche. La température de ce traitement varie généralement de 70 à 150°C, et de préférence est au moins égale à 110°C. Le traitement peut être réalisé selon une méthode connue de l'homme du métier, par exemple au moyen de lampes à rayonnement infrarouge.

Le fait de déposer une couche de protection sur le substrat en verre, avant de déposer le pigment minéral et la couche d'émail permet avantageusement d'améliorer, voire de supprimer la teinte grise que l'on pouvait observer après cuisson dans les procédés de l'art antérieur. La couche de protection joue un rôle de couche barrière pendant l'étape de cuisson et empêche la migration du pigment vers le substrat et par conséquent sa coloration non souhaitée.

De façon préférée, la couche de protection déposée à l'étape a) du procédé selon l'invention est une couche d'oxyde de silicium ou d'oxyde de titane. Encore plus préférentiellement, la couche de protection est une couche d'oxyde de silicium. Elle peut par exemple être déposée par magnétron. Ce type de couche présente l'avantage d'être transparente et neutre et par conséquent de ne pas modifier la coloration du substrat, ni les propriétés optiques du substrat revêtu de la couche de protection. Le dépôt par magnétron permet d'obtenir une couche suffisamment dense qui remplit bien son rôle de couche de protection.

La couche de protection présente l'avantage d'être résistante dans le temps et au vieillissement.

De façon préférée, l'épaisseur de la couche de protection est comprise entre 10 et 150 nm. Encore plus préférentiellement, elle est comprise entre 20 et 100 nm.

Selon un mode de réalisation, l'étape a) du procédé selon l'invention peut consister à déposer deux couches successives à base d'oxydes de nature et d'épaisseur différente.

En fonction de la couche de protection choisie, il est possible de donner une légère coloration au substrat revêtu. Ainsi le dépôt d'une couche de protection en oxyde de titane permet de donner une coloration légèrement jaune au substrat revêtu. Contrairement à la teinte grise non souhaitée observée dans les procédés de l'art antérieur, cette coloration est homogène quelle que soit la température de cuisson de l'émail et est stable dans le temps.

Le dépôt de la couche de pigments exempte de fritte de verre réalisé à l'étape b) peut se faire par tout moyen connu de l'homme du métier, notamment par sérigraphie, à plat ou rotative.

Le pigment minéral est choisi de préférence parmi les pigments qui permettent de conférer une couleur noire après l'étape de cuisson. A titre d'exemples, on peut citer les pigments à base de chrome, de fer, de manganèse, de cuivre et/ou de cobalt, notamment sous forme d'oxydes ou de sulfures. Bien que les pigments à base de chrome permettent d'avoir une couleur noire intense, ils ne sont pas préférés du fait des problèmes liés à leur toxicité potentielle et à leur recyclage. Ainsi, de façon préférée, le pigment minéral utilisé dans la couche exempte de fritte de verre est exempt de chrome.

Avantageusement, le pigment minéral noir présente une clarté L* telle que définie dans le modèle de représentation chromatique CIE Lab (1931) qui est inférieure ou égale à 15, de préférence inférieure ou égale à 10, mesurée sur le panneau de verre final.

Lorsque le dépôt est effectué par sérigraphie, le pigment est en général mélangé avec un médium organique qui permet d'ajuster la viscosité afin que le passage du mélange au travers des mailles de l'écran de sérigraphie puisse se faire correctement. La viscosité du mélange varie généralement de 80 à 120 Poises, de préférence de l'ordre de 100 Poises.

Le médium organique a aussi pour fonction d'assurer une fixation temporaire des pigments jusqu'à l'application de la couche suivante de composition d'émail.

Le médium organique doit pouvoir être éliminé dès le début de l'étape de cuisson de l'émail afin d'éviter l'apparition de pores et de craquelures dans l'émail final. Il s'agit en général d'un solvant organique, de préférence à base d'un mélange d'alcools « lourds » ou terpéniques (« huile de pin »), éventuellement associé à une ou plusieurs résines qui renforcent la fixation temporaire du pigment à la surface du panneau.

De façon préférée, l'épaisseur de la couche de pigments exempte de fritte de verre déposée sur le panneau en verre varie de 6 à 10 µm.

Le dépôt de la composition d'émail est effectué par sérigraphie. La sérigraphie est une technique d'impression bien connue qui utilise un écran de sérigraphie constitué d'un tissu sur lequel le(s) motif(s) à imprimer sont(sont) reproduit(s) et un râcle permettant d'appliquer une force de cisaillement suffisante pour faire passer la composition d'émail au travers des mailles de l'écran par les ouvertures correspondant au(x) motif(s) à imprimer et la déposer sur un support. L'écran de sérigraphie doit présenter une ouverture de maille compatible avec la taille des particules contenues dans la composition d'émail. Les fils constituant ledit écran peuvent être des fils en acier ou en une matière polymérique, par exemple en polyester. Le nombre de fils par centimètre varie en général de 120 à 180 et de préférence est de l'ordre de 150. De préférence, le diamètre des fils varie de 25 à 35 µm.

La composition d'émail à sérigraphier est obtenue en mélangeant la fritte de verre et le pigment minéral avec un médium organique tel que défini précédemment. Par « fritte de verre », on entend une composition vitrifiable sous la forme de poudre et à base d'oxydes. Conformément au procédé selon l'invention, la fritte de verre se présente sous la forme de particules ayant une dimension comparable à celle des particules de pigments mis en oeuvre à l'étape b). Grâce à la faible dimension de ses particules combinée à une température de ramollissement également faible, la fritte de verre peut migrer aisément vers la surface du panneau en englobant les pigments qui se trouvent ainsi liés solidement et durablement au verre.

La fritte de verre utilisée dans le procédé selon l'invention est exempte d'oxyde de plomb PbO pour des raisons liées à la préservation de l'environnement. De préférence, la fritte de verre est un borosilicate à base d'oxyde de bismuth Bi₂O₃ et/ou d'oxyde de zinc ZnO. Par exemple, la fritte de verre à base de Bi₂O₃ contient 35 à 75 % en poids de SiO₂ et 20 à 40 % en poids de Bi₂O₃ et avantageusement 25 à 30 %. Une telle fritte de verre présente une température de ramollissement qui varie de 550 à 580°C, de préférence est égale à 568°C. Par exemple, la fritte de verre à base de ZnO contient 35 à 75 % en poids de SiO₂ et 4 à 10 % en poids de ZnO. Une telle fritte de verre présente une température de ramollissement inférieure à 600°C, qui varie de 560 à 590°C, de préférence est égale à 577°C.

Comme déjà indiqué, le pigment minéral compris dans la couche d'émail possède une couleur différente du pigment utilisé dans la couche exempte de fritte de verre et confère préférentiellement une couleur différente du noir. De préférence, le pigment est choisi de telle sorte qu'il présente une coloration blanche après l'étape c) de cuisson. Ce pigment est notamment l'oxyde de titane TiO₂. Avantageusement, le pigment minéral blanc présente une clarté L* telle que définie dans le modèle de représentation chromatique CIE Lab (1931) qui varie de 65 à 85, mesurée sur le panneau de verre final. Le pigment peut être d'une couleur différente que le blanc, et est par exemple à base de Cr₂O₃ (coloration verte), de Co₃O₄ (coloration bleue) ou de Fe₂O₃ (coloration orange). La proportion de pigments dans la composition de fritte de verre varie de 5 à 25 % en poids, de préférence 10 à 20 %.

La viscosité du mélange comprenant la fritte de verre, le pigment minéral et le médium organique varie généralement de 100 à 300 Poises, de préférence 180 à 200 Poises.

De façon préférée, l'épaisseur de la couche d'émail déposée sur la couche de pigments varie de 10 à 100 µm, de préférence 20 à 80 µm.

Eventuellement, on peut appliquer sur la couche d'émail, avant l'étape de cuisson c), une couche supplémentaire de pigments de couleur différente des pigments présents dans la première couche et la couche d'émail. Cette couche supplémentaire est généralement appliquée de telle sorte qu'elle recouvre partiellement la surface de la couche d'émail, ce qui permet d'obtenir des motifs polychromes plus ou moins complexes. Le cas échéant, après qu'une couche ait été déposée et avant l'application de la couche suivante, on peut lui appliquer un traitement thermique en vue de réduire la quantité de médium organique. La température de traitement varie généralement de 70 à 150°C, et de préférence est au moins égale à 110°C. Le traitement peut être réalisé selon une méthode connue de l'homme du métier, par exemple au moyen de lampes à rayonnement infrarouge.

Dans l'étape c) du procédé selon la présente invention, le panneau de verre est traité à une température dite « de cuisson » qui permet à la fritte de verre de fondre pour former une couche de verre qui fixe les particules de pigments à la surface du panneau. Dans le domaine des émaux, la température de cuisson est la température minimale à laquelle on observe un frittage « suffisant » de la composition d'émail, ce frittage suffisant se traduisant notamment par un accrochage important au verre du panneau. L'homme du métier sait mesurer cette température de cuisson, par exemple en passant à la surface de l'émail (après que celui-ci a été porté à la température de traitement, puis refroidi) un stylo comportant une pointe métallique reliée à un ressort qui délivre une force de 20 Newtons et en notant la température de traitement la plus basse pour laquelle l'émail ne peut pas être décroché du verre. La température de cuisson doit être suffisamment élevée pour cuire la fritte de verre et éventuellement tremper le verre, mais pas trop importante afin que la feuille de verre ne présente pas de déformations apparentes indésirables. En général la température de cuisson varie de 620 à 700°C, de préférence de 640 à 660°C.

Dans l'étape d) de nettoyage, les pigments qui se situent en dehors des motifs sérigraphiés et qui n'ont pas été fixés par l'émail sont éliminés. Leur élimination peut être effectuée par tout moyen connu, par exemple mécanique, notamment par chiffonnage, brossage à sec ou humide, ou jet d'eau.

Le panneau de verre imprimé obtenu par le procédé selon l'invention peut être utilisé seul ; dans ce cas il est préférable que le panneau ait été préalablement traité thermiquement dans des conditions de température telles que le verre final soit au moins durci, et de préférence soit trempé, afin que ledit panneau puisse être utilisé en toute sécurité.

Le panneau de verre obtenu par le procédé selon l'invention peut être constitué de tout type de verre, par exemple un verre silico-sodo-calcique, notamment obtenu par le procédé « Float ». En règle générale, il s'agit d'une feuille de verre dont l'épaisseur peut varier dans une large mesure selon l'application visée. A titre indicatif pour un panneau destiné à entrer dans la constitution d'un vitrage pour bâtiment, cette épaisseur varie de 2 à 20 mm, de préférence 4 à 12. De préférence, notamment pour des raisons de sécurité des personnes, le panneau de verre est associé à une ou plusieurs feuilles de verre, notamment répondant à la définition donnée précédemment, par l'intermédiaire d'une ou plusieurs feuilles d'une matière thermoplastique ayant des propriétés adhésives à chaud pour former un panneau de verre feuilleté. A titre d'exemple de feuille de matière thermoplastique, on peut citer les feuilles de butyrate de butyral de polyvinyle (PVB), d'éthylène-acétate de vinyle (EVA), de polyuréthane et de polycarbonate. Le nombre de feuilles de verre dans le panneau feuilleté est fonction de sa taille et de la sollicitation mécanique à laquelle il est soumis. En général le panneau feuilleté comprend au plus 6 feuilles de verre y compris le panneau de verre imprimé, et de préférence 2 à 4 feuilles de verre.

L'association du panneau imprimé et des feuilles de verre avec les feuilles de matière thermoplastique est effectuée selon les méthodes connues, notamment utilisant un autoclave.

L'invention est illustrée au moyen des exemples suivants, non limitatifs et des figures jointes dans lesquelles :
- la Figure 1 représente un verre float PLANILUX® sur lequel on a déposé un pigment noir et qui a subi une cuisson à des températures variant entre 600 et 700°C.
- la Figure 2 représente différents substrats de verre float PLANILUX® sur lesquels une couche de protection d'oxyde de silicium a éventuellement été déposée avec différentes épaisseurs.
- la Figure 3 représente un motif imprimé sur un substrat en verre float PLANILUX® avec ou sans couche de protection.
- la Figure 4 représente différents substrats de verre float PLANILUX® sur lesquels une couche d'oxyde de silicium a été déposée par différents procédés puis revêtus de pigments noirs.

### Exemple 1 :

Un pigment noir exempt de chrome est déposé par le procédé dit de sérigraphie, à l'aide d'un écran 150.27 (150 étant le nombre de fils/cm et 27 étant l'épaisseur en µm du fil polyester constituant l'écran) sur un substrat en verre de type PLANILUX®. L'épaisseur déposée est de 6 µm : elle est mesurée à l'aide d'un perthomètre laser juste après l'étape de sérigraphie et avant le séchage à 140 °C. On effectue ensuite une cuisson de ce substrat recouvert de pigment noir dans un four à gradient à des températures comprises entre 600 et 700°C puis un nettoyage du verre cuit.

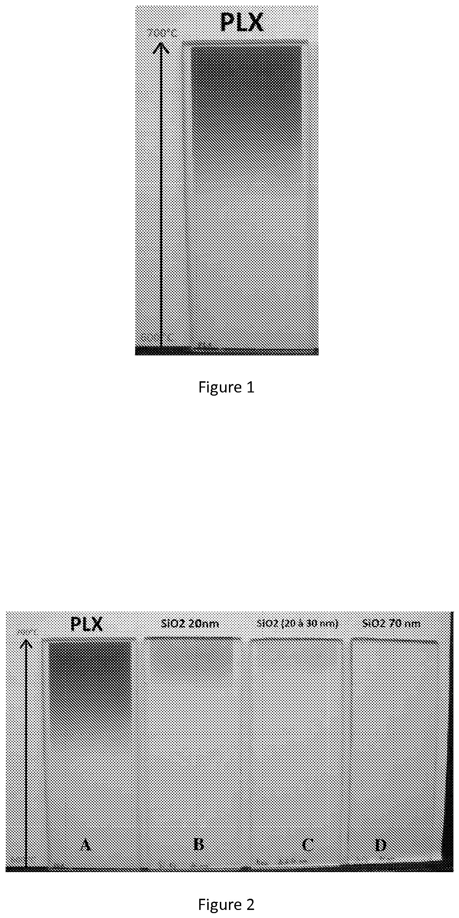

La photo du substrat obtenu après cuisson et nettoyage est donnée à la figure 1.

On observe nettement un gradient de couleur lié à la migration plus ou moins importante en fonction de la température du pigment vers le substrat.

Des tests équivalents ont été effectués sur des substrats revêtus d'une couche de protection à base d'oxyde de silicium déposée plus ou moins épaisse. La figure 2 est une photo sur laquelle quatre différents échantillons ont été testés.

L'échantillon A correspond à celui qui était représenté sur la figure 1, comme expliqué ci-dessus. L'échantillon B correspond à un substrat en verre Planilux® sur lequel on a déposé par magnétron une couche de silice d'une épaisseur de 20 nm avant de déposer un pigment minéral noir et d'effectuer une cuisson du substrat ainsi préparé dans un four à gradient entre 600 et 700°C. L'échantillon C est identique à l'échantillon B à la différence près que la couche de silice est plus épaisse (environ 25 nm). L'échantillon D est identique aux échantillons B et C à la différence près que la couche de protection en silice a une épaisseur de 70 nm. L'étape de dépôt du pigment noir est effectué dans les mêmes conditions expérimentales que celles décrites ci-dessus pour l'échantillon A.

On constate en comparant ces différents échantillons que l'effet de la couche de protection est notable : même pour une faible épaisseur de couche de silice, la teinte grise diminue nettement et n'apparait que plus faiblement pour des températures de cuisson élevées. En augmentant l'épaisseur de la couche de protection, la teinte grise disparait totalement même à une température de cuisson élevée de l'ordre de 700°C.

### Exemple 2 :

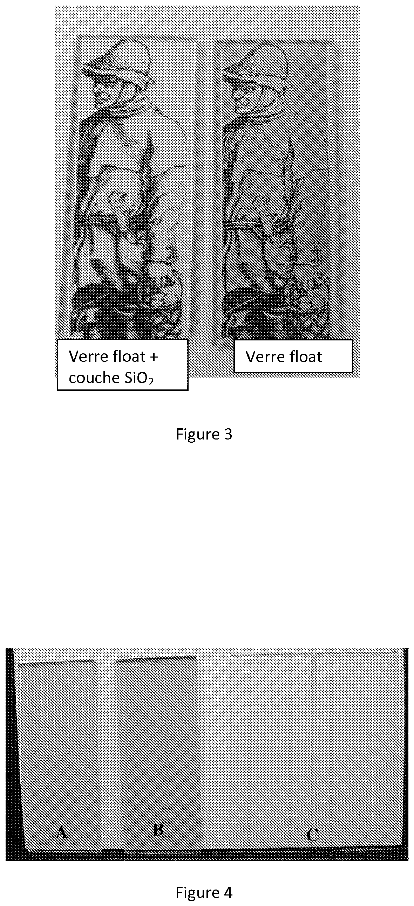

La figure 3 représente un motif imprimé selon le procédé de la présente invention, avec ou sans couche de protection en silice.

Une couche de pigment noir a été déposée par sérigraphie sur deux substrats différents 2a et 2b ; le substrat 2a correspondant à un panneau de verre clair et le substrat 2b correspondant à un panneau de verre clair sur lequel on a déposé par magnétron une couche de silice de 25 nm.

L'écran de sérigraphie utilisé est écran 150.27 (150 fils/cm et fils de 27 µm). L'épaisseur moyenne de la couche (humide) de pigments noirs déposée sur le verre est égale à 6 µm. Les verres ont ensuite été introduits dans un dispositif de séchage équipé de lampes infrarouges opérant à une température de l'ordre de 145 à 155° C afin d'éliminer le médium organique.

Le motif représentant le personnage visible sur la figure 3 a alors été déposé par sérigraphie également sur les deux verres contenant le pigment noir. L'émail utilisé est blanc et composé de fritte à base d'oxyde de bismuth, et de pigment à base d'oxyde de titane. Après séchage de l'émail à une température comprise entre 145 et 155 °C, les verres ont été cuits à une température homogène de trempe standard (environ 655 °C).

Les pigments non fixés sont éliminés par brossage et lavage à l'eau. Le teintage du verre a été empêché à l'aide de la couche de protection SiO₂ préalablement déposée sur l'un des substrats.

### Exemple 3

On a imprimé sur différents verres revêtues d'une couche contenant du SiO₂ un pigment minéral noir, le procédé utilisé étant le même que dans l'exemple 1.

Les couches utilisées ont été déposées par différents procédés (magnétron (A), Chemical Vapor Deposition (B) « CVD » ainsi qu'une combinaison de ces deux techniques (C).

La figure 4 représente les 3 types de verres à couches sur lesquels le pigment noir a été déposé. Les verres ont ensuite été lavés et cuits à une température de 650°C.

Ces différents verres à couche (contenant du SiO₂) ont bien permis d'empêcher la migration du pigment noir à la surface du verre.

## Revendications

1. Procédé de fabrication d'un panneau en verre à vision à sens unique comportant un ou plusieurs motifs discrets en émail, composés de plusieurs couches en exacte coïncidence, **caractérisé en ce que** :
a) on dépose sur le substrat en verre au moins une couche de protection à base d'oxydes d'une épaisseur supérieure ou égale à 10 nm,
b) on dépose sur la couche de protection au moins deux couches de composition différentes, la composition de l'une des couches renfermant au moins un pigment minéral et étant exempte de fritte de verre, la composition de l'autre couche étant un émail renfermant au moins une fritte de verre et au moins un pigment minéral de couleur différente de celui de la couche exempte de fritte de verre, la couche exempte de fritte de verre étant déposée sur tout ou partie de la surface du panneau et la couche d'émail étant déposée par sérigraphie sous la forme du ou des motifs désirés,
c) on chauffe le panneau revêtu desdites couches à une température suffisante pour cuire l'émail, et
d) on élimine les pigments non fixés par l'émail situés en dehors du ou des motifs, les particules de pigment(s) et les particules de(s) fritte(s) de verre ayant une dimension similaire, notamment une distribution granulométrique telle que 50 % des particules ont une taille inférieure à 7 µm.

2. Procédé selon la revendication 1 **caractérisé en ce qu'**on dépose sur la couche de protection la couche exempte de fritte de verre sur une épaisseur comprise entre 4 et 15 µm, puis on dépose par sérigraphie la couche d'émail sur une épaisseur comprise entre 10 et 100 µm.

3. Procédé selon la revendication 1 **caractérisé en ce qu'**on dépose sur la couche de protection la couche d'émail sur une épaisseur comprise entre 10 et 100 µm, puis on dépose la couche exempte de fritte de verre sur une épaisseur comprise entre 4 et 30 µm.

4. Procédé selon l'une des revendications 1 à 3 **caractérisé en ce que** la couche de protection déposée à l'étape a) est une couche d'oxyde de silicium ou d'oxyde de titane.

5. Procédé selon la revendication précédente **caractérisé en ce que** la couche de protection est une couche d'oxyde de silicium déposée par magnétron.

6. Procédé selon l'une des revendications 1 à 5 **caractérisé en ce que** l'épaisseur de la couche de protection est comprise entre 10 et 150 nm, de préférence entre 20 et 100 nm.

7. Procédé selon l'une des revendications précédentes **caractérisé en ce que** l'étape a) consiste à déposer deux couches successives de protection de nature et d'épaisseur différente.

8. Procédé selon l'une des revendications 1 à 7 **caractérisé en ce que** le pigment minéral utilisé dans la couche exempte de fritte de verre est choisi parmi les pigments qui permettent de conférer une couleur noire après l'étape de séchage.

9. Procédé selon la revendication 8, **caractérisé en ce que** le pigment est à base de chrome, de fer, de manganèse, de cuivre et/ou de cobalt, de préférence sous forme d'oxydes ou de sulfures.

10. Procédé selon l'une des revendications 1 à 9, **caractérisé en ce que** la fritte de verre est exempte d'oxyde de plomb PbO.

11. Procédé selon la revendication 10 **caractérisé en ce que** la fritte de verre est un borosilicate à base d'oxyde de bismuth Bi₂O₃ et/ou d'oxyde de zinc ZnO.

12. Procédé selon la revendication 10, **caractérisé en ce que** la fritte de verre contient 35 à 75 % en poids de SiO₂ et 20 à 40 % en poids de Bi₂O₃, avantageusement 25 à 30 %, ou 4 à 10 % en poids de ZnO.

13. Procédé selon l'une des revendications 11 ou 12, **caractérisé en ce que** la fritte de verre renfermant du Bi₂O₃ présente une température de ramollissement qui varie de 550 à 580°C, de préférence est égale à 568°C, et la fritte renfermant du ZnO présente une température de ramollissement inférieure à 600°C.

14. Procédé selon l'une des revendications 1 à 13, **caractérisé en ce que** le pigment minéral de l'émail possède une couleur différente du pigment utilisé dans la couche exempte de fritte de verre et confère préférentiellement une couleur différente du noir.

15. Procédé selon la revendication 14, **caractérisé en ce que** le pigment de la couche d'émail est choisi parmi les pigments qui permettent de conférer une couleur blanche après l'étape de séchage et est préférentiellement à base de TiO₂.

16. Procédé selon la revendication 14, **caractérisé en ce que** le pigment utilisé dans la couche d'émail est d'une couleur différente que le blanc, et est par exemple à base de Cr₂O₃, de Co₃O₄, ou de Fe₂O₃.

17. Procédé selon l'une des revendications 1 à 16, **caractérisé en ce que** la proportion de pigments dans la composition de l'émail varie de 5 à 25 % en poids, de préférence 10 à 20 %.

## Patentansprüche

1. Verfahren zum Herstellen einer Glasplatte mit Sicht in eine einzige Richtung, die ein oder mehrere diskrete Muster aus Email, die aus mehreren Schichten in präziser Übereinstimmung bestehen, umfasst, **dadurch gekennzeichnet, dass**:
a) auf dem Glassubstrat mindestens eine Schutzschicht auf der Basis von Oxiden mit einer Stärke größer oder gleich 10 nm abgeschieden wird,
b) auf der Schutzschicht mindestens zwei Schichten mit unterschiedlicher Zusammensetzung abgeschieden werden, wobei die Zusammensetzung einer der Schichten mindestens ein mineralisches Pigment enthält und keine Glasfritte enthält, wobei die Zusammensetzung der anderen Schicht ein Email ist, das mindestens eine Glasfritte und mindestens ein mineralisches Pigment mit einer Farbe enthält, die von der der Schicht, die keine Glasfritte enthält, unterschiedlich ist, wobei die Schicht, die keine Glasfritte enthält, auf der gesamten oder einem Teil der Oberfläche der Platte abgeschieden wird, und die Emailschicht durch Serigrafie in der Form des oder der gewünschten Muster abgeschieden wird,
c) die mit den Schichten beschichtete Platte auf eine Temperatur erhitzt wird, die ausreicht, um das Email zu brennen, und
d) die Pigmente, die von dem Email nicht fixiert sind, die außerhalb des oder der Muster liegen, eliminiert werden, wobei die Partikel von Pigment(en) und die Partikel des/der Glasfritte(n) ein ähnliches Maß haben, insbesondere eine Korngrößenverteilung derart, dass 50 % der Partikel eine Größe kleiner als 7 µm haben.

2. Verfahren nach Anspruch 1, **dadurch gekennzeichnet, dass** auf der Schutzschicht die Schicht, die keine Glasfritte aufweist, auf einer Stärke abgeschieden wird, die zwischen 4 und 15 µm liegt, dann durch Serigrafie die Emailschicht auf einer Stärke abgeschieden wird, die zwischen 10 und 100 µm liegt.

3. Verfahren nach Anspruch 1, **dadurch gekennzeichnet, dass** auf der Schutzschicht die Emailschicht auf einer Stärke abgeschieden wird, die zwischen 10 und 100 µm liegt, man die Schicht, die keine Glasfritte enthält, auf einer Stärke abgeschieden wird, die zwischen 4 und 30 µm liegt.

4. Verfahren nach einem der Ansprüche 1 bis 3, **dadurch gekennzeichnet, dass** die Schutzschicht, abgeschieden bei Schritt a), eine Siliziumoxidschicht oder Titanoxidschicht ist.

5. Verfahren nach dem vorhergehenden Anspruch, **dadurch gekennzeichnet, dass** die Schutzschicht eine Siliziumoxidschicht ist, abgeschieden durch Magnetron.

6. Verfahren nach einem der Ansprüche 1 bis 5, **dadurch gekennzeichnet, dass** die Stärke der Schutzschicht zwischen 10 und 150 nm, bevorzugt zwischen 20 und 100 nm liegt.

7. Verfahren nach einem der vorhergehenden Ansprüche, **dadurch gekennzeichnet, dass** der Schritt a) darin besteht, zwei aufeinanderfolgende Schutzschichten mit unterschiedlicher Beschaffenheit und Stärke abzuscheiden.

8. Verfahren nach einem der Ansprüche 1 bis 7, **dadurch gekennzeichnet, dass** das mineralische Pigment, das in der Schicht, die keine Glasfritte enthält, verwendet wird, aus den Pigmenten ausgewählt ist, die es erlauben, nach dem Trocknungsschritt eine schwarze Farbe zu verleihen.

9. Verfahren nach Anspruch 8, **dadurch gekennzeichnet, dass** das Pigment auf der Basis von Chrom, Eisen, Mangan, Kupfer und/oder Cobalt, bevorzugt in Form von Oxiden oder Sulfiden, vorliegt.

10. Verfahren nach einem der Ansprüche 1 bis 9, **dadurch gekennzeichnet, dass** die Glasfritte kein Bleioxid PbO enthält.

11. Verfahren nach Anspruch 10, **dadurch gekennzeichnet, dass** die Glasfritte ein Borsilikat auf der Basis von Wismutoxid Bi₂O₃ und/oder Zinkoxid ZnO ist.

12. Verfahren nach Anspruch 10, **dadurch gekennzeichnet, dass** die Glasfritte 35 bis 75 Gew.-% SiO₂ und 20 bis 40 Gew.-% Bi₂O₃, vorteilhafterweise 25 bis 30 oder 4 bis 10 Gew.-% ZnO enthält.

13. Verfahren nach einem der Ansprüche 11 oder 12, **dadurch gekennzeichnet, dass** die Glasfritte, die Bi₂O₃ enthält, eine Erweichungstemperatur aufweist, die von 550 bis 580 °C variiert, bevorzugt gleich 568 °C ist, und die Fritte, die ZnO enthält, eine Erweichungstemperatur kleiner als 600 °C aufweist.

14. Verfahren nach einem der Ansprüche 1 bis 13, **dadurch gekennzeichnet, dass** das mineralische Pigment des Emails eine Farbe besitzt, die von dem Pigment unterschiedlich ist, das in der Schicht, die keine Glasfritte enthält, verwendet wird, und bevorzugt eine andere Farbe als Schwarz verleiht.

15. Verfahren nach Anspruch 14, **dadurch gekennzeichnet, dass** das Pigment der Emailschicht aus den Pigmenten ausgewählt ist, die es erlauben, nach dem Trocknungsschritt eine weiße Farbe zu verleihen, und die bevorzugt auf der Basis von TiO₂ vorliegt.

16. Verfahren nach Anspruch 14, **dadurch gekennzeichnet, dass** das Pigment, das in der Emailschicht verwendet wird, eine von Weiß unterschiedliche Farbe hat und zum Beispiel auf der Basis von Cr₂O₃, von Co₃O₄, oder von Fe₂O₃ vorliegt.

17. Verfahren nach einem der Ansprüche 1 bis 16, **dadurch gekennzeichnet, dass** der Anteil an Pigmenten in der Zusammensetzung des Emails von 5 bis 25 Gew.-%, bevorzugt von 10 bis 20 % variiert.

## Claims

1. A process for manufacturing a one-way vision glass pane comprising one or more separate enamel patterns composed of a number of exactly aligned layers, **characterized in that**:
a) at least one protective layer based on oxides, having a thickness greater than or equal to 10 nm, is deposited on the glass substrate,
b) at least two layers of different compositions are deposited on the protective layer, the composition of one of the layers containing at least one mineral pigment and being free of glass frit, the composition of the other layer being an enamel containing at least one glass frit and at least one mineral pigment having a color different from that of the layer free of glass frit, the layer free of glass frit being deposited over all or some of the surface of the pane and the layer of enamel being deposited by screen printing in the shape of the desired pattern(s),
c) the pane coated with said layers is heated at a temperature sufficient to fire the enamel, and
d) the pigments not fixed by the enamel that are located outside of the pattern(s) are removed, the particles of pigment(s) and the particles of glass frit(s) having a similar size, in particular a particle size distribution such that 50% of the particles have a size of less than 7 µm.

2. The process as claimed in claim 1, **characterized in that** the layer free of glass frit is deposited on the protective layer over a thickness of between 4 and 15 µm, then the layer of enamel is deposited by screen printing over a thickness of between 10 and 100 µm.

3. The process as claimed in claim 1, **characterized in that** the layer of enamel is deposited on the protective layer over a thickness of between 10 and 100 µm, then the layer free of glass frit is deposited over a thickness of between 4 and 30 µm.

4. The process as claimed in one of claims 1 to 3, **characterized in that** the protective layer deposited in step a) is a layer of silicon oxide or of titanium oxide.

5. The process as claimed in the preceding claim, **characterized in that** the protective layer is a layer of silicon oxide deposited by magnetron sputtering.

6. The process as claimed in one of claims 1 to 5, **characterized in that** the thickness of the protective layer is between 10 and 150 nm, preferably between 20 and 100 nm.

7. The process as claimed in one of the preceding claims, **characterized in that** step a) consists in depositing two successive protective layers of different nature and thickness.

8. The process as claimed in one of claims 1 to 7, **characterized in that** the mineral pigment used in the layer free of glass frit is selected from the pigments that make it possible to impart a black color after the drying step.

9. The process as claimed in claim 8, **characterized in that** the pigment is based on chromium, iron, manganese, copper and/or cobalt, preferably in the form of oxides or sulfides.

10. The process as claimed in one of claims 1 to 9, **characterized in that** the glass frit is free of lead oxide PbO.

11. The process as claimed in claim 10, **characterized in that** the glass frit is a borosilicate based on bismuth oxide Bi₂O₃ and/or zinc oxide ZnO.

12. The process as claimed in claim 10, **characterized in that** the glass frit contains 35 to 75 wt% of SiO₂ and 20 to 40 wt% of Bi₂O₃ and advantageously 25 to 30 wt%, or 4 to 10 wt% of ZnO.

13. The process as claimed in either of claims 11 and 12, **characterized in that** the glass frit containing Bi₂O₃ has a softening point that varies from 550 to 580°C and preferably is equal to 568°C, and the frit containing ZnO has a softening point below 600°C.

14. The process as claimed in one of claims 1 to 13, **characterized in that** the mineral pigment of the enamel has a different color from the pigment used in the layer free of glass frit and preferably imparts a color other than black.

15. The process as claimed in claim 14, **characterized in that** the pigment of the enamel layer is selected from the pigments that make it possible to impart a white color after the drying step and is preferably based on TiO₂.

16. The process as claimed in claim 14, **characterized in that** the pigment used in the enamel layer is of a color other than white, and is for example based on Cr₂O₃, Co₃O₄, or Fe₂O₃.

17. The process as claimed in one of claims 1 to 16, **characterized in that** the proportion of pigments in the composition of the enamel varies from 5 to 25 wt%, preferably 10 to 20 wt%.
